# EUROPEAN PATENT SPECIFICATION

(11) **EP 0 420 994 B1**
(45) Date of publication and mention of the grant of the patent: **01.10.1997**
(21) Application number: 90906338.0
(22) Date of filing: 19.04.1990
(51) Int. Cl.: G06F 12/16, G11C 5/00

(54) **MEMORY CARTRIDGE**
SPEICHERPATRONE
CARTOUCHE DE MEMOIRE

(30) Priority: 20.04.1989 JP 101026/89
(43) Date of publication of application: 10.04.1991
(73) Proprietor: NINTENDO CO. LIMITED, Higashiyama-ku Kyoto (JP)
(72) Inventor: OKADA, Satoru, NINTENDO Co., Ltd., Kyoto-shi, Kyoto 605 (JP)
(74) Representative: Mackenzie, Andrew Bryan
(86) International application number: PCT/JP90/00511
(87) International publication number: WO 90/13085

(56) References cited:
- EP-A- 0 109 504
- EP-A- 0 268 419
- EP-A- 0 276 450
- WO-A-82/00535
- JP-A-55 130 000
- JP-A-62 271 031
- JP-U-62 117 650
- US-A- 4 332 009

## Description

### Field of the Art

The present invention relates to a memory cartridge. More specifically, the present invention relates tc a memory cartridge which is loaded to a data processing apparatus including a microprocessor in an attachable/detachable manner and backed-up by a back-up power source.

### Prior Art

For example, in Japanese Patent Laying-Open No. 63-245535 laid open on October 12, 1988, a memory cartridge which is attachable to or detachable from a data processing apparatus such as a home video game machine is disclosed. In this prior art, a memory cartridge is provided with a RAM and the RAM is backed-up by a battery.

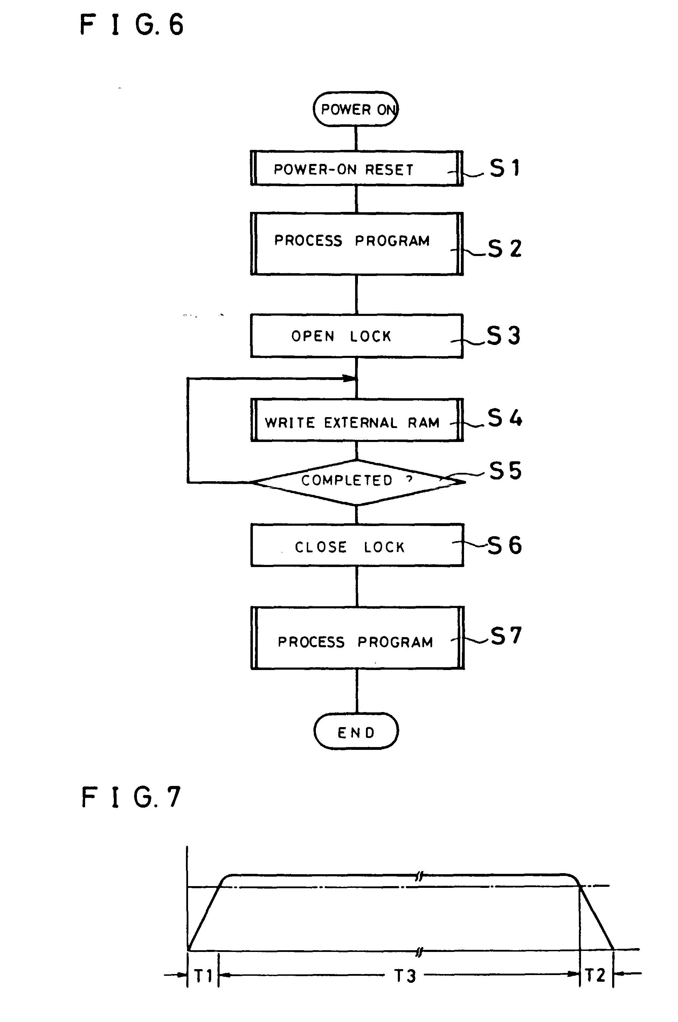

In an external memory cartridge having such an external RAM, if data is written in the RAM during a voltage astable period T1 or T2 as shown in Fig. 7, the data is occasionally destroyed. Since a power-on (or power-off) reset is normally effected in the data processing apparatus during the period T1 or T2, it is impossible to access to the external RAM, but in a case where a period during when the poweron (or power-off) reset is effected and the voltage astable period T1 (or T2) shown in Fig.7 deviate from each other, the external RAM is occasionally accessed in the voltage astable period T1 or T2. Because when the power source of the data processing apparatus becomes more than a given level, a reset state is released so that it becomes possible to access to the external RAM, but a power source voltage is not always a voltage being necessary for a normal operation at a timing when the reset state is released. If an operation at this time is a writing operation to the external RAM accidentally, the data becomes to be destroyed.

As a method for solving such a problem, there is a method in which a power source voltage of the data processing apparatus is strictly watched and a power-on (power-off) reset is released at only a timing when the power source voltage becomes a voltage level by which a normal operation can be made stably.

However, in order to provide with such a power source voltage watching circuit, additional components are required, and therefore, it becomes a high cost as a whole system.

EP-A-268419 describes a memory cartridge including a memory area divided into a plurality of banks. The cartridge also includes a multi-memory controller having a plurality of registers into which data representing bank change-over conditions may be written. When the cartridge is used with a data processing unit which can write data into the registers the data processing unit is able to select an arbitrary bank at an arbitrary time and use that bank.

US-A-4332009 describes a circuit for protecting memory from inadvertent alteration by a data processing system. The data processing system generates a key code prior to generation of an address signal for addressing the memory. The protection circuit includes decode circuitry for receiving the key code and for generating a decoded key code. The decoded key code is passed to a latch which generates a control signal which is NANDed with the address signal to provide a composite access signal to permit alteration of data stored in the memory.

EP-A-0109504 describes a protection system for storage and I/0 devices. It operates to restrict a microprocessor to fetching data from a particular sub-range of addresses within the total memory map. In this way programs may be isolated from reading particular areas of a memory map and in particular the copying of proprietary software stored in a ROM is prevented.

EP-276450 describes a data protection system usable to prevent unauthorised access to memories or communication lines. The system includes a register which holds a stored coded key, a lock value must be entered into the system and without agreement between the code key and lock value data access is not possible.

Therefore, a principal object of the present invention is to provide a memory cartridge in which it is possible to prevent data from being undesirably written to or eliminated from an external RAM with a simple scheme.

According to the present invention as defined in claim 1, there is provided a memory cartridge removably attachable to a data processing apparatus, said memory cartridge comprising an external RAM for storing data generated by said data processing apparatus, and a program ROM for storing program data executable by said data processing apparatus characterized in that
said program ROM further stores first key data for allowing said data processing apparatus to access said external RAM, and in that said memory cartridge further comprises
holding means for receiving and holding key data read from said program ROM by said data processing apparatus according to said program data;
first key detecting means for generating a first key detection signal when the key data read from said program ROM and held in said holding means corresponds to said first key data; and
first controlling means for enabling said external RAM in response to said first key detection signal when no selection signal (/CS) is applied from said data processing apparatus to said program ROM.

Preferably, the memory cartridge can be loaded to a data processing apparatus in an attachable/detachable manner, which comprises an external RAM; a program ROM which is programmed in advance so as to generate first key data representing that the external RAM is accessible; holding means for holding the first key data read from the program ROM; and control means for enabling the external RAM in response to a selection signal from the data processing apparatus when the first key data is held by the holding means.

The data read from the program ROM is held in the holding means. When the data is data other than the first key data, the control means does not permit to access or select the external RAM by the data processing apparatus. Then, when the data held in the holding means is the first key data, in response to the selection signal from the data processing apparatus, the selection signal is applied to the external RAM by the controlling means, whereby the external RAM becomes accessible.

In accordance with the present invention, since the external RAM can be accessed by the data processing apparatus only when the key data is read from the program ROM, it is possible to prevent the data from being undesirably written to or eliminated from the external RAM. More specifically, the probability is very small that a step for reading the key data from the program ROM is executed in a state where a power source voltage is astable, and resultingly, the external RAM is selected and becomes accessible only a time during when the power source voltage is stable.

The objects and other objects, features, aspects and advantages of the present invention will become more apparent from the following detailed description of the embodiments of the present invention when taken in conjunction with accompanying drawings.

### Brief Description of the Drawings

Fig. 1 is a circuit diagram showing a bank changing circuit of one embodiment in accordance with the present invention.

Fig. 2 is a perspective view showing one example of a gaming apparatus to which the present invention is applicable.

Fig. 3 is a block diagram showing a whole structure of Fig. 2 embodiment.

Fig. 4 is a memory map showing an address space of a CPU core shown in Fig. 3.

Fig. 5 is an illustrative view showing a portion of a program ROM.

Fig. 6 is a flowchart showing an operation of the embodiment.

Fig. 7 is an illustrative view showing a state of a power source voltage of a main unit of a data processing apparatus.

### The Best Mode for Embodying the Invention

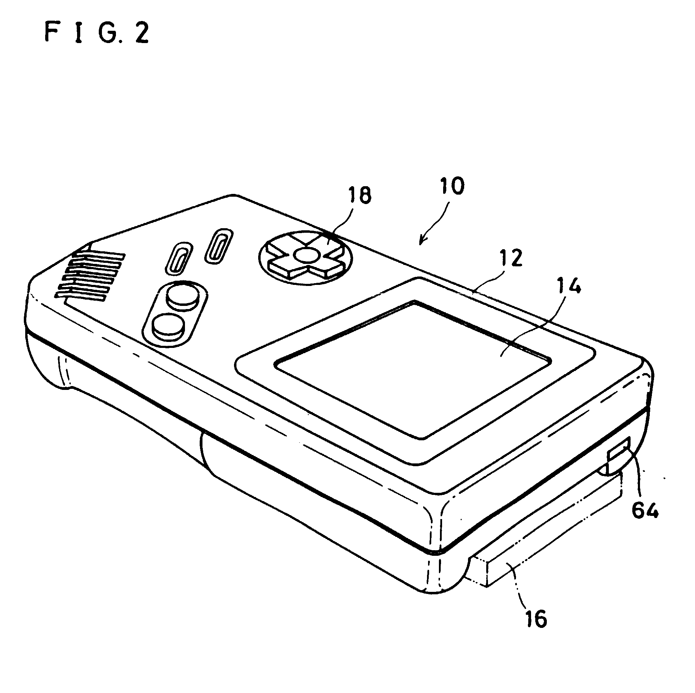

Fig. 2 is a perspective view showing one example of a hand-held liquid crystal gaming apparatus to which the present invention is applicable. However, it is pointed out in advance that the present invention is applicable to such a hand-held liquid crystal gaming apparatus as well as any memory cartridges each of which is loaded to a main unit in an attachable/detachable manner and incorporates a RAM backed-up by a back-up battery.

This hand-held liquid crystal gaming apparatus (hereinafter, simply called as "gaming apparatus") 10 includes a body 12 which is provided with on an upper surface thereof a LCD panel 14 in which display segments are arranged in dot in accordance with a dot-matrix system.

On a rear surface of the body 12, an insertion port (not shown) is formed at an upper portion, and a memory cartridge 16 is inserted thereto in an attachable/detachable manner as shown by a two-dotted line in Fig. 2. Then, a program ROM is incorporated in the memory cartridge 16, and game program data is stored in the program ROM in advance. Therefore, when the memory cartridge 16 is loaded to the body 12 of the gaming apparatus 10, the game program is executed and an image for a game can be displayed on the LCD panel 14.

A cross-key switch 18 which is operated when a game character thus displayed on the LCD panel 14 is to be moved is provided on the upper surface of the body 12. The cross-key switch has four direction designating portions and, by depressing any one of the same, it is possible to move the game character upward or downward, or leftward or rightward.

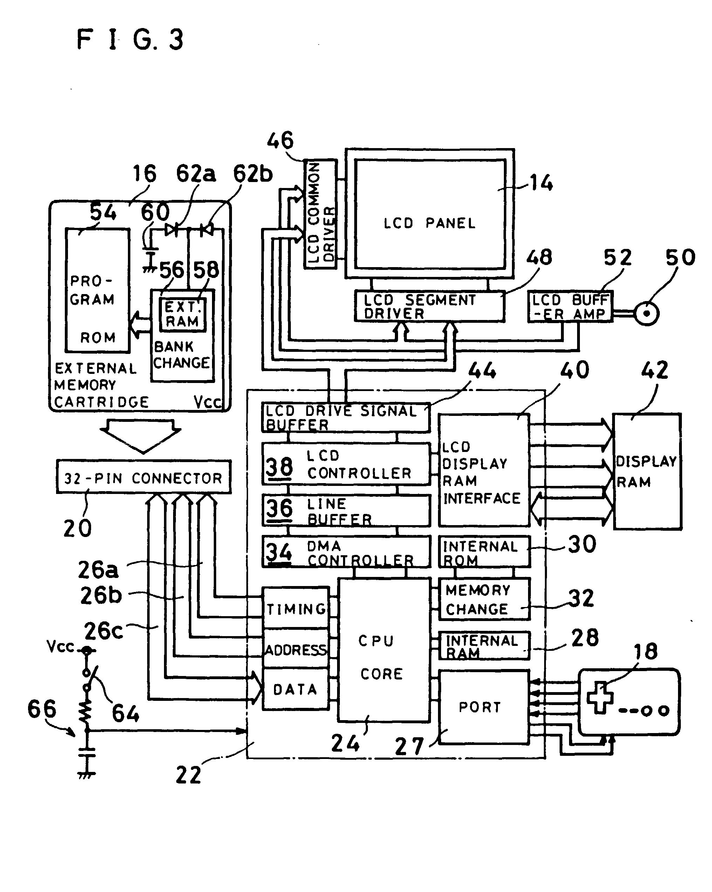

With reference to Fig. 3, the above described memory cartridge 16 is connected to a CPU 22 housed in the body 12 by a 32-pin connector 20. The CPU 22 includes a CPU core 24 which is connected to the 32-pin connector 20 via a control bus 26a, an address bus 26b and a data bus 26c. Therefore, when the memory cartridge 16 is loaded, the CPU core 24 and the memory cartridge 16 is connected to each other.

A key matrix of the cross-key switch 18 and etc. shown in Fig. 2 is further connected to the CPU core 24 through a port 27. Then, in association with the CPU core 24, an internal RAM (working RAM) 28 and an internal ROM 30 are provided. The internal ROM 30 is accessed by the CPU core 24 only when the same is selected by a memory changing circuit 32.

The CPU core 24 outputs display data to an LCD controller 38 through a line buffer 36 under the control by a DMA controller 34. Then, the LCD controller 38 is connected to a display RAM 42 via an LCD display RAM interface 40. Although not shown, the display RAM 42 includes a character RAM and a video RAM (VRAM). Therefore, the LCD controller 38 converts the display data outputted from the CPU core 24 into an LCD drive signal which is outputted from the display RAM 42. More specifically, the display data from the CPU core 24 designates addresses of the character RAM and the VRAM so that a character (or object) signal and a background signal can be outputted therefrom, and respective signals are mixed with each other by the LCD controller 38 so as to become the LCD drive signal.

Then, the LCD drive signal is applied to an LCD common driver 46 and an LCD segment driver 48 through an LCD drive signal buffer 44. Therefore, an image in accordance with the display data from the CPU core 24 can be displayed on the LCD panel 14 by the LCD common driver 46 and the LCD segment driver 48.

In addition, there is provided with an intensity volume 50 which is connected to an LCD buffer amplifier 52, and therefore, by operating the intensity volume 50, it is possible to adjust the intensity on the LCD panel 14.

As described above, the memory cartridge 16 in accordance with the present invention is loaded to the data processing apparatus, i.e. CPU 22 in an attachable/detachable manner. The memory cartridge 16 includes a program ROM 54 which stores the program data for operating the CPU core 24 of the CPU 22. The program ROM 54 has a memory area of 2M bits, for example. The memory cartridge 16 further includes a bank changing circuit 56 for changing banks of the program ROM 54, and an external RAM 58 is included in the bank changing circuit 56. However, the external RAM 58 may be provided separately from the bank changing circuit 56.

A back-up power source is applied to the bank changing circuit 56, i.e. the external RAM 58 from a battery 60 such as a lithium battery. That is, a voltage from the battery 60 is applied to the external RAM 58 through a forward direction diode 62a. However, the external RAM 58 is further supplied with a voltage Vcc from the body through a forward direction diode 62b. Therefore, the voltage of the battery 60 is applied to the external RAM 58 only when the power source voltage Vcc of the body is less than a reverse bias voltage of the diode 62a.

The control bus 26a, address bus 26b and data bus 26c being connected to the CPU core 24 are connected to the program ROM 54 and the bank changing circuit 56 of the memory cartridge 16 through the connector 20.

In addition, in association with the CPU 22, as shown in Fig. 2, the body 12 is provided with a power source switch 64 through which the power source voltage Vcc is applied. A reset circuit 66 is connected to the voltage source Vcc and, when the power source voltage Vcc through the reset circuit 66 is less than a predetermined level, the CPU core 24 outputs a reset signal so as to disable all the circuits. When the voltage from the reset circuit 66, i.e. the power source voltage Vcc reaches the predetermined level, the CPU core 24 releases such a reset state so as to enable the whole.

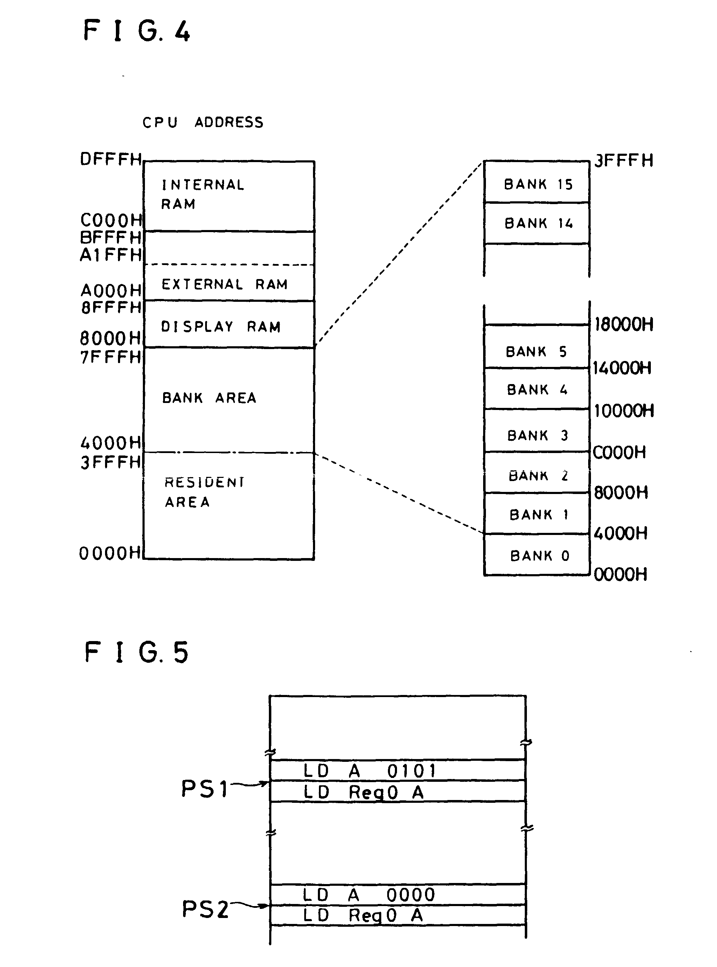

An address space of the CPU core 24 is from the address "0000H" to the address "DFFFH" as shown in Fig. 4. It is to be noted that "H" is representative of a hexadecimal number. The addresses "0000H - 7FFFH" are assigned for the program ROM 54 of the memory cartridge 16. Then, addresses "8000H - 9FFFH" are assigned for the display RAM 42, addresses "A000H - BFFFH" are assigned for the external RAM 58, and addresses "C000H - DFFFH" are assigned for the internal RAM 28. In this embodiment shown, since the external RAM 58 is 2048 bits (= 512 x 4 bits), practically, the address space "A000H - A1FFH" of the CPU core 24 is used for the external RAM 58.

In addition, since the program ROM 54 is 2M bits (= 16k bite x 16) as described above, 16 banks in total from the bank 0 to the bank 15 are suitably selected by the bank changing circuit 56 to be used.

In addition, the addresses "0000H - 3FFFH" for the program ROM 54 are so-called a home bank which is used as a resident area.

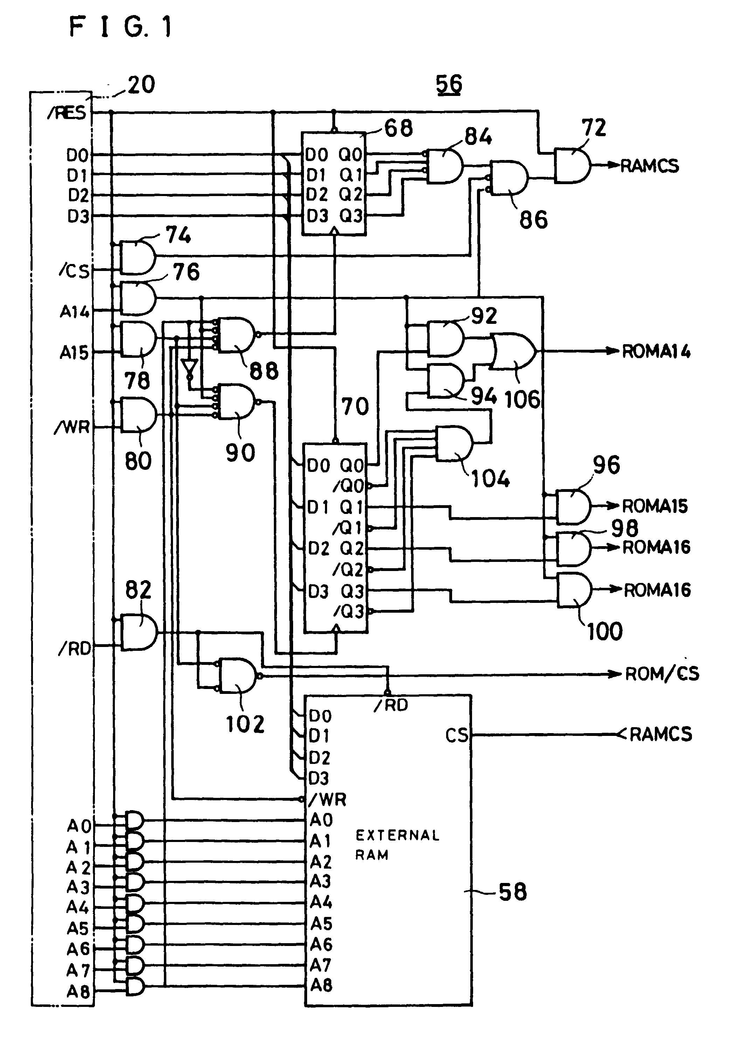

With reference to Fig. 1, the bank changing circuit 56 includes the external RAM 58, as described above. Address bits A0 - A8 of the address bus 26b of the CPU core 24 are connected to address inputs A0 - A8 of the external RAM 58 through the connector 20. However, the address data is applied to the external RAM 58 through an AND gate only when a reset signal /RES ("/" is a symbol representative of an inverted signal, and so forth on) is "1". As described above, the reset signal /RES is "0" until the voltage from the reset circuit 66, that is, the power source voltage Vcc reaches a predetermined level and becomes "1" during a voltage stable period (T3 in Fig. 7).

The above described reset signal /RES is further applied as a clear input of a first register (Reg0) 68, a clear input of a second register (Regl) 70 and respective one inputs of AND gates 72 - 82.

The lower 4 bits D0 - D3 of the data bus 26c of the above described CPU core 24 is given to respective data inputs D0 - D3 of the first register 68, second register 70 and the external RAM 58 through the connector 20.

The first register 68 is a register for storing "key data" from the program ROM 54 and the second register 70 is a register for storing the bank selection data for the program ROM 54.

Outputs Q0 - Q3 of the first register 68 are applied to a 4-input AND gate 84 as respective inputs thereof. At this time, only the outputs Q0 and Q2 are inverted to be applied to the AND gate 84. Then, as well as an output of the AND gate 84 the inverted outputs of the AND gate 74 and 76 are applied to a 3-input AND gate 86 as one inputs thereof. An output of the AND gate 86 is applied to the other input of the above described AND gate 72.

In addition, to the other input of the AND gate 74, a chip select signal /CS from the CPU core 24 is applied via the connector 20. The chip select signal /CS is outputted from the CPU core 24 when the CPU 24 accesses to the external RAM 58.

In addition, the upper 2 bits A14 and A15 of the address bus 26b of the CPU core 24 are respectively applied to respective other inputs of the above described AND gates 76 and 78 through the connector 20. Respective outputs of these AND gates 76 and 78 are inverted and applied to NAND gates 88 and 90 each having 4 inputs as respective inputs thereof. The output of the AND gate 76 is further applied to respective one inputs of AND gates 92 - 100. Then, the output of the AND gate 78 is inverted to be further applied to one input of a NAND gate 102.

A write signal /WR from the CPU core 24 is applied to the other input of the AND gate 80 via the connector 20, and a read signal /RD from the CPU core 24 is applied to the AND gate 82 via the connector 20. Then, an output of the AND gate 80 is inverted to be applied to the NAND gates 88 and 90 as respective one inputs thereof, and to the external RAM 58 as a write signal /WR thereof. Furthermore, an output of the AND gate 82 is inverted to be applied to the other input of the above described NAND gate 102 an output of which becomes a selection signal ROM/CS for selecting the program ROM 54.

Then, an output of the above described NAND gate 88 is applied to the first register 68 as a clock input thereof, and an output of the NAND gate 90 is applied to the second register 70 as a clock input thereof.

Inverted outputs /Q0 - /Q3 of the second register 70 are applied to respective inputs of a 4-input AND gate 104. An output of the AND gate 104 is applied to the other input of the above described AND gate 94, and to the other input of the AND gate 92, the output Q0 from the second register 70 is applied. Outputs of these AND gates 92 and 94 become an address bit ROMA14 for the program ROM 54 through an OR gate 106. Then, to respective other inputs of the AND gates 94, 98 and 100, the outputs Q1, Q2 and Q3 of the second register 70 are applied, respectively, and respective outputs of the AND gates 94, 98 and 100 become address bits ROMA15, ROMA16 and ROMA17 for the program ROM 54. Therefore, these AND gates 96 - 100 generate address data more than the address "4000H" of the resident area of the program ROM 54, that is, designation data of the bank 0 - bank 15.

As shown in Fig. 5, the program ROM 54 includes a program step PS1 for storing a program for opening a lock of the external RAM 58 and a program step PS2 for storing a program for closing the lock in arbitrary program addresses. The program step PS1 includes programs, for example, LDA0101 (load data "0101" to an accumulator) and LDReg0A (load data of the accumulator to Reg0, i.e. the first register 68). The program step PS2 includes programs, for example, LDA0000 (load data "0000" to the accumulator) and LDReg0A (load data of the accumulator to Reg0, i.e. the first register 68).

Therefore, when the program step PS1 of the program ROM 54 is executed, "0101" is loaded to the data inputs D0 -D3. Therefore, when the first register 68 receives a latch signal from the NAND gate 88, the data "0101" is loaded into the first register 68 and the output of the AND gate 84 becomes "1". On the other hand, since the CPU core 24 outputs the chip select signal /CS for the external RAM 58 at this time, when the address bit A14 becomes "0", that is, when the change from the internal RAM 28 to the external RAM 58 is effected, "1" is outputted from the succeeding AND gate 86, and the same is applied to the AND gate 72. To the other input of the AND gate 72, the reset signal /RES which is "0" during when the power source voltage Vcc is astable and becomes "1" when the power source voltage Vcc becomes stable as described above is applied. Therefore, the AND gate 72 applies a chip select signal RAMCS to the external RAM 58 when the power source voltage becomes stable. Thus, the data for opening the lock, "0101", for example is loaded into the first register 68 from the program ROM 54, and the external RAM 58 is selected only when the power source voltage becomes stable. In addition, as "first key data", arbitrary data other than "0101" can be utilized.

In addition, the program step PS2 of the program ROM 54 is executed, data "0000" is stored in the first register 68. Therefore, the output of the AND gate 84 is "0" and, in response thereto, the output of the AND gate 86 also becomes "0", and the output of the AND gate 72, i.e. the external RAM selection signal RAMCS is held as "0". Accordingly, after the program step PS2 of the program ROM 54 is executed, it becomes impossible to access to the external RAM 58 any more. Thus, the program step PS2 closes the lock of the external RAM 58. In addition, arbitrary data other than "0000" may be utilized as the second key data for closing the lock.

With reference to Fig. 6, when the power source switch 64 (Fig. 2 and Fig. 3) is turned-on, the CPU core 24 causes a power-on reset state in the step S1 until an output voltage from the reset circuit 66 reaches a predetermined level. Then, in the succeeding step S2, the program of the program ROM 54 is executed to perform a suitable data processing based upon the program.

Then, in the step S3, the program step PS1 described previously is executed to open the lock of the external RAM 58. Then, in the next step S4, the CPU core 24 writes the data to the external RAM 58 and, when the completion of the writing is detected in the step S5, in the succeeding step S6, the CPU core 24 executes the program step PS2 described previously, whereby the lock of the external RAM 58 is closed. Thereafter, in the step S7, other program is executed, and the process is terminated by turning the power source switch 64 off.

Thus, the CPU core 24 opens and closes the lock of the external RAM 58 by executing the program step PS1, i.e. the step S3 and the program step PS2, i.e. the step S6 of the program ROM 54, and during only that period, it is possible to access to the external RAM 58 to write or read the data.

In addition, the present invention is applicable not only a gaming apparatus as the above described embodiment but also an arbitrary data processing apparatus of a system in which an external memory having an external RAM which is backed-up is loaded thereto.

## Claims

1. A memory cartridge (16) removably attachable to a data processing apparatus (10), said memory cartridge comprising an external RAM (58) for storing data generated by said data processing apparatus, and a program ROM (54) for storing program data executable by said data processing apparatus characterized in that
said program ROM further stores first key data for allowing said data processing apparatus to access said external RAM, and in that said memory cartridge further comprises
holding means (68) for receiving and holding key data read from said program ROM by said data processing apparatus according to said program data;
first key detecting means (84) for generating a first key detection signal when the key data read from said program ROM and held in said holding means corresponds to said first key data; and
first controlling means (86, 72) for enabling said external RAM in response to said first key detection signal when no selection signal (/CS) is applied from said data processing apparatus to said program ROM.

2. A memory cartridge according to claim 1, wherein said program ROM (54) further stores second key data for inhibiting said data processing apparatus from accessing said external RAM, and further comprising
second key detecting means (84) for generating a second key detection signal when the key data read from said program ROM and held in said holding means corresponds to said second key data; and
second controlling means (86, 72) for disabling said external RAM in response to said second key detection signal.

3. A memory cartridge according to claim 1 or claim 2, wherein said data processing apparatus generates a write signal (/WR), and said first controlling means includes first detecting means (74) for detecting a fact that no selection signal (/CS) is applied from said data processing apparatus to said program ROM, and
said external RAM (58) is enabled for writing data into said external RAM in response to said first key detection signal, an output from said first detecting means and said write signal.

4. A memory cartridge according to claim 3, wherein said data processing apparatus further generates a read signal (/RD), and
said external RAM (58) is enabled for reading data from said external RAM in response to said first key detection signal, said output of said first detecting means and said read signal.

5. A memory cartridge according to claim 3 or claim 4, wherein said data processing apparatus further generates a status signal (/RES) when a voltage to be supplied becomes stable after a power source is turned-on, and
said first detecting means outputs said output signal when no selection signal is outputted from said data processing apparatus and said status signal is outputted from said data processing apparatus.

6. A memory cartridge (16) according to claim 1 or claim 2, removably attachable to a data processing apparatus (10) which generates a write signal (/WR), a read signal (/RD), address signals, and execution data for executing a desired program, said memory cartridge comprising data input terminals (D0-D3) for receiving the data suppplied from said data processing apparatus, address input terminals (A0-A8, A14, A15) for receiving the address data supplied from said data processing apparatus, the external RAM (58) having data inputs (D0-D3) connected to said data input terminals and address inputs (A0-A8) connected to said address data input terminals, and the program ROM (54) being arranged for storing said program further characterized by the holding means being connected to said data input terminals and the controlling means (86, 72) being arranged such that writing of data into said external RAM is enabled in response to said write signal, and reading of data from said external RAM is enabled in response to said read signal.

7. A memory cartridge according to claim 6, wherein said controlling means inhibits the reading of data from said external RAM when said selection signal is outputted from said data processing apparatus.

8. A memory cartridge according to any one of claims 6 and 7, wherein said address data input terminals are connected to a plurality of address lines, and said program ROM has a plurality of memory banks each having a memory space accessible by the number of lines of said address lines, and said address data is applied to a lower address of said address data input terminals and bank selection data is applied to an upper address of said address data input terminals, further comprising
bank selection data holding means (70) for receiving and holding said bank selection data,
write means (90) for writing said bank selection data to be applied to said address data input terminals in said bank selection data holding means when address data for designating said bank selection data holding means is outputted from said data processing apparatus, and
bank selection data supplying means (92-106) for applying said bank selection data held in said bank selection data holding means to said upper address of said program ROM.

9. A memory cartridge according to claim 8, wherein said bank selection data is stored in said program ROM and applied through said data processing apparatus.

10. A memory cartridge according to any one of claims 6 to 9, wherein said data processing apparatus generates a status signal (/RES) when a voltage to be supplied becomes stable after a power source is turned-on, and said controlling means enables said external RAM at least in part in response to said status signal.

11. A memory cartridge according to any one of claims 6 to 10, wherein said memory cartridge is supplied with a power source when said memory cartridge is attached to said data processing apparatus, further comprising
a battery (60) for supplying a back-up electric power to said external RAM, and
switching means (62a, 62b) for switching the electric power from said battery and the electric power from said data processing apparatus to supply to said external RAM.

## Patentansprüche

1. Speichermodul (16), das lösbar in eine Datenverarbeitungseinrichtung (10) eingebaut werden kann und einen externen Schreib-/Lesespeicher (RAM 58) zum Speichern von in der Datenverarbeitungseinrichtung erzeugten Daten und einen Programm-Nur-Lese-Speicher (Programm-ROM 54) zum Speichern von in der Datenverarbeitungseinrichtung ausführbaren Programmdaten aufweist, dadurch gekennzeichnet,
daß das Programm-ROM (54) ferner erste Schlüsseldaten speichert, die der Datenverarbeitungseinrichtung erlauben, auf das externe RAM (58) zuzugreifen, und daß das Speichermodul ferner folgende Merkmale aufweist:
eine Halteeinrichtung (68) zum Empfangen und Halten von Schlüsseldaten, die von der Datenverarbeitungseinrichtung aus dem Programm-ROM entsprechend den Programmdaten gelesen werden;
eine erste Schlüsselerfassungseinrichtung (84) zum Erzeugen eines ersten Schlüsselerfassungssignals, wenn die Schlüsseldaten, die aus dem Programm-ROM gelesen und in der Halteeinrichtung gehalten werden, den ersten Schlüsseldaten entsprechen; und
eine erste Steuereinrichtung (86, 72) zum Freigeben des externen RAM als Reaktion auf das erste Schlüsselerfassungssignal, wenn kein Auswahlsignal (/CS) von der Datenverarbeitungseinrichtung am Programm-ROM anliegt.

2. Speichermodul nach Anspruch 1, wobei das Programm-ROM (54) ferner zweite Schlüsseldaten speichert, welche die Datenverarbeitungseinrichtung daran hindern, auf das externe RAM zuzugreifen, mit folgenden weiteren Merkmalen:
einer zweiten Schlüsselerfassungseinrichtung (84) zum Erzeugen eines zweiten Schlüsselerfassungssignals, wenn die Schlüsseldaten, die aus dem Programm-ROM gelesen und in der Halteeinrichtung gehalten werden, den zweiten Schlüsseldaten entsprechen; und
einer zweiten Steuereinrichtung (86, 72) zum Sperren des externen RAM als Reaktion auf das zweite Schlüsselerfassungssignal.

3. Speichermodul nach Anspruch 1 oder 2, wobei die Datenverarbeitungseinrichtung ein Schreibsignal (/WR) erzeugt, und die erste Steuereinrichtung eine erste Erfassungseinrichtung (74) aufweist, die erfaßt, ob kein Auswahlsignal (/CS) von der Datenverarbeitungseinrichtung am Programm-ROM anliegt, und
das externe RAM (58) zum Schreiben von Daten in das externe RAM freigegeben wird, sobald das erste Schlüsselerfassungssignal, ein Ausgangssignal der ersten Erfassungseinrichtung und das Schreibsignal vorliegen.

4. Speichermodul nach Anspruch 3, wobei die Datenverarbeitungseinrichtung ferner ein Lesesignal (/RD) erzeugt, und
das externe RAM (58) zum Lesen von Daten aus dem externen RAM freigegeben wird, sobald das erste Schlüsselerfassungssignal, das Ausgangssignal der ersten Erfassungseinrichtung und das Lesesignal vorliegen.

5. Speichermodul nach Anspruch 3 oder 4, wobei die Datenverarbeitungseinrichtung ferner ein Zustandssignal (/RES) erzeugt, sobald eine Versorgungsspannung stabil wird, nachdem eine Energiequelle eingeschaltet wird, und
die erste Erfassungseinrichtung das Ausgangssignal ausgibt, wenn kein Auswahlsignal aus der Datenverarbeitungseinrichtung ausgegeben wird und das Zustandssignal von der Datenverarbeitungseinrichtung ausgegeben wird.

6. Speichermodul (16) nach Anspruch 1 oder 2, das lösbar in eine Datenverarbeitungseinrichtung (10) eingebaut werden kann, die ein Schreibsignal (/WR), ein Lesesignal (/RD), Adreßsignale und Ausführungsdaten zum Ausführen eines gewünschten Programms erzeugt, wobei das Speichermodul Dateneingangsanschlüsse (D0-D3) zum Empfangen der von der Datenverarbeitungseinrichtung gelieferten Daten und Adreßeingangsanschlüsse (A0-A8, A14, A15) zum Empfangen der von der Datenverarbeitungseinrichtung gelieferten Adreßdaten aufweist, das externe RAM (58) mit den Dateneingangsanschlüssen verbundene Dateneingänge (D0-D3) und mit den Adreßeingangsanschlüssen verbundene Adreßeingänge (A0-A8) besitzt, und das Programm-ROM (54) zum Speichern des besagten Programms ausgebildet ist, ferner dadurch gekennzeichnet, daß die Halteeinrichtung mit den Dateneingangsanschlüssen verbunden ist und die Steuereinrichtung (86, 72) so ausgebildet ist, daß als Reaktion auf das Schreibsignal das Einschreiben von Daten in das externe RAM freigegeben wird und als Reaktion auf das Lesesignal das Auslesen von Daten aus dem externen RAM freigegeben wird.

7. Speichermodul nach Anspruch 6, wobei die Steuereinrichtung das Auslesen von Daten aus dem externen RAM verhindert, wenn von der Datenverarbeitungseinrichtung das Auswahlsignal ausgegeben wird.

8. Speichermodul nach Anspruch 6 oder 7, wobei die Adreßeingangsanschlüsse mit einer Mehrzahl von Adreßleitungen verbunden sind, und das Programm-ROM eine Mehrzahl von Speicherbereichen aufweist, die jeweils einen Speicherraum haben, der durch die Anzahl von Adreßleitungen zugänglich ist, und die Adreßdaten an eine untere Adresse der Adreßeingangsanschlüsse gelegt werden und Speicherbereichsauswahldaten an eine obere Adresse der Adreßeingangsanschlüsse gelegt werden, ferner mit
einer Speicherbereichsauswahldaten-Halteeinrichtung (70) zum Empfangen und Halten der Speicherbereichsauswahldaten,
einer Schreibeinrichtung (90) zum Einschreiben der an die Adreßeingangsanschlüsse zu legenden Speicherbereichsauswahldaten in die Speicherbereichsauswahldaten-Halteeinrichtung, wenn von der Datenverarbeitungseinrichtung Adreßdaten zum Bezeichnen der Speicherbereichsauswahldaten-Halteeinrichtung ausgegeben werden, und
einer Speicherbereichsauswahldaten-Liefereinrichtung (92-106) zum Anlegen der in der Speicherbereichsauswahldaten-Halteeinrichtung gehaltenen Speicherbereichsauswahldaten an die obere Adresse des Programm-ROM.

9. Speichermodul nach Anspruch 8, wobei die Speicherbereichsauswahldaten im Programm-ROM gespeichert werden und durch die Datenverarbeitungseinrichtung angelegt werden.

10. Speichermodul nach einem der Ansprüche 6 bis 9, wobei die Datenverarbeitungseinrichtung ein Zustandssignal (/RES) erzeugt, sobald eine Versorgungsspannung stabil wird, nachdem eine Energiequelle eingeschaltet wird, und zumindest teilweise als Reaktion auf das Zustandssignal die Steuereinrichtung das externe RAM freigibt.

11. Speichermodul nach einem der Ansprüche 6 bis 10, wobei das Speichermodul mit Energie versorgt wird, sobald es in die Datenverarbeitungseinrichtung eingebaut wird, ferner mit
einer Batterie (60) zum Liefern einer elektrischen Ersatzversorgung an das externe RAM, und
einer Schalteinrichtung (62a, 62b) zum Umschalten zwischen einer elektrischen Energieversorgung des externen RAM aus der Batterie und einer elektrischen Energieversorgung des externen RAM aus der Datenverarbeitungseinrichtung.

## Revendications

1. Cartouche mémoire (16) pouvant être fixée de façon amovible à un appareil (10) de traitement de données, ladite cartouche mémoire comprenant une mémoire vive externe RAM (58) pour mémoriser des données engendrées par ledit appareil de traitement de données, et une mémoire morte ROM (54) pour mémoriser des données de programme pouvant être exécutées par ledit appareil de traitement de données, caractérisée en ce que:
ladite mémoire ROM de programme mémorise en outre une première donnée de clé pour permettre audit appareil de traitement de données d'accéder à ladite mémoire externe RAM, et en ce que ladite cartouche mémoire comprend en outre :
des moyens (68) de maintien pour recevoir et maintenir la donnée de clé lue à partir de ladite mémoire ROM de programme par ledit appareil de traitement de données conformément à ladite donnée de programme ;
des premiers moyens (84) de détection de clé pour engendrer un premier signal de détection de clé lorsque la donnée de clé lue à partir de ladite mémoire de programme ROM et maintenue dans ledit moyen de maintien correspond à ladite première donnée de clé; et
des premiers moyens de commande (86, 72) pour valider ladite mémoire externe RAM en réponse audit premier signal de détection de clé lorsqu'aucun signal de sélection (/CS) n'est appliqué en provenance dudit appareil de traitement de données en direction de ladite mémoire de programme ROM.

2. Cartouche mémoire selon la revendication 1, dans laquelle ladite mémoire de programme ROM (54) mémorise en outre une seconde donnée de clé pour empêcher que ledit appareil de traitement de données accède à ladite mémoire externe RAM, et comprenant en outre :
des seconds moyens de détection de clé (84) pour engendrer un second signal de détection de clé lorsque la donnée de clé lue à partir de ladite mémoire de programme ROM et maintenue dans lesdits moyens de maintien correspond à ladite seconde donnée de clé ; et
des seconds moyens de commande (86, 72) pour invalider ladite mémoire externe RAM en réponse audit second signal de détection de clé.

3. Cartouche mémoire selon la revendication 1 ou la revendication 2, dans laquelle ledit appareil de traitement de données engendre un signal d'écriture (/WR), et lesdits premiers moyens de commande comprennent des premiers moyens de détection (74) pour détecter le fait qu'aucun signal de sélection (/CS) n'est appliqué en provenance dudit appareil de traitement à ladite mémoire de programme ROM, et
ladite mémoire externe RAM (58) est validée pour écrire une donnée dans ladite mémoire externe RAM en réponse audit premier signal de détection de clé, au signal de sortie provenant desdits premiers moyens de détection et audit signal d'écriture.

4. Cartouche mémoire selon la revendication 3, dans laquelle ledit appareil de traitement de données engendre en outre un signal de lecture (/RD), et
ladite mémoire externe RAM (58) est validée pour lire la donnée en provenance de ladite mémoire externe RAM en réponse audit premier signal de détection de clé, audit signal de sortie desdits premiers moyens de détection et audit signal de lecture.

5. Cartouche mémoire selon la revendication 3 ou la revendication 4, dans laquelle ledit appareil de traitement de données engendre en outre un signal de statut (/RES) lorsqu'une tension qui doit être fournie devient stable après branchement d'une source de puissance, et
lesdits premiers moyens de détection envoient ledit signal de sortie lorsqu'aucun signal de sélection n'est envoyé en provenance dudit appareil de traitement de données, et que ledit signal de statut est envoyé à partir dudit appareil de traitement de données.

6. Cartouche mémoire (16) selon la revendication 1 ou la revendication 2, pouvant être fixée de façon amovible à un appareil (10) de traitement de données qui engendre un signal d'écriture (/WR), un signal de lecture (/RD), des signaux d'adresse et des données d'exécution pour exécuter un programme désiré, ladite cartouche mémoire comprenant des bornes d'entrée de données (D0-D3) pour recevoir les données fournies à partir dudit appareil de traitement de données, des bornes d'entrée d'adresse (A0-A8, A14, A15) pour recevoir les données d'adresse fournies à partir dudit appareil de traitement de données, la mémoire RAM externe (58) comportant des entrées de données (D0-D3) connectées auxdites bornes d'entrée de données et auxdites entrées d'adresse (A0-A8) connectées auxdites bornes d'entrée de données d'adresse, et la mémoire de programme ROM (54) étant disposée de façon à mémoriser ledit programme, ladite cartouche étant caractérisée en outre par le fait que lesdits moyens de maintien sont connectés auxdites bornes d'entrée de données, et les moyens de commande (86, 72) sont disposés de telle façon que l'écriture des données dans ladite mémoire externe RAM est validée en réponse audit signal d'écriture, et la lecture des données en provenance de ladite mémoire externe RAM est validée en réponse audit signal de lecture.

7. Cartouche mémoire selon la revendication 6, dans laquelle lesdits moyens de commande empêchent la lecture des données provenant de ladite mémoire externe RAM lorsque ledit signal de sélection est envoyé en provenance de l'appareil de traitement de données.

8. Cartouche mémoire selon l'une quelconque des revendications 6 et 7, dans laquelle lesdites bornes d'entrée de données d'adresse sont connectées à une pluralité de lignes d'adresse, et ladite mémoire programme ROM comporte une pluralité de plages de mémoires comprenant chacune un espace de mémoire accessible par le nombre de lignes desdites lignes d'adresse, et ladite donnée d'adresse est appliquée à une adresse inférieure desdites bornes d'entrée de données d'adresse et la donnée de sélection de plage est appliquée à une adresse supérieure desdites bornes d'entrée de données d'adresse, comprenant en outre :
des moyens (70) de maintien de donnée de sélection de plage pour recevoir et maintenir ladite donnée de sélection de plage,
des moyens d'écriture (90) pour écrire ladite donnée de sélection de plage qui doit être appliquée auxdites bornes d'entrée de données d'adresses dans lesdits moyens de maintien de données de sélection de plage lorsque la donnée d'adresse pour désigner lesdits moyens de maintien de données de sélection de plage est envoyée à partir dudit appareil de traitement de données, et
des moyens (92-106) de fourniture de donnée de sélection de plage pour appliquer ladite donnée de sélection de plage maintenue dans lesdits moyens de maintien de donnée de sélection de plage à ladite adresse supérieure dudit programme ROM.

9. Cartouche mémoire selon la revendication 8, dans laquelle ladite donnée de sélection de plage est mémorisée dans ledit programme ROM et est appliquée au travers dudit appareil de traitement de données.

10. Cartouche mémoire selon l'une quelconque des revendications 6 à 9, dans laquelle ledit appareil de traitement de données engendre un signal de statut (/RES) quand une tension devant être fournie devient stable après branchement d'une source de puissance, et lesdits moyens de commande valident ladite mémoire externe RAM au moins en partie en réponse audit signal de statut.

11. Cartouche mémoire selon l'une quelconque des revendications 6 à 10, dans laquelle ladite cartouche mémoire est alimentée par une source de puissance lorsque ladite cartouche mémoire est fixée audit appareil de traitement de données, comprenant en outre :
une batterie (60) pour fournir une puissance électrique de secours à ladite mémoire externe RAM, et
des moyens de commutation (62a, 62b) pour commuter ladite puissance électrique fournie par ladite batterie et la puissance électrique provenant dudit appareil de traitement de données pour alimenter ladite mémoire externe RAM.
